# EUROPEAN PATENT SPECIFICATION

(11) **EP 0 394 475 B1**
(45) Date of publication and mention of the grant of the patent: **18.11.1998**
(21) Application number: 89910930.0
(22) Date of filing: 28.09.1989
(51) Int. Cl.: B32B 15/08, C23C 14/02, C23C 14/20, H01G 4/18

(54) **ALUMINIUM VACUUM EVAPORATION FILM AND ITS PRODUCTION METHOD**
ALUMINIUM-VAKUUMVERDÄMPFUNGSFILM UND VERFAHREN ZUR HERSTELLUNG
FILM D'ALUMINIUM PAR EVAPORATION SOUS VIDE ET PROCEDE DE PRODUCTION

(30) Priority: 28.09.1988 JP 243433/88; 29.09.1988 JP 245258/88; 18.04.1989 JP 98367/89
(43) Date of publication of application: 31.10.1990
(73) Proprietor: TORAY INDUSTRIES, INC., Tokyo 103-8666 (JP)
(72) Inventor: SUZUKI, Motoyuki, Yamashina-ku Kyoto-shi Kyoto 607 (JP); DEGUCHI, Yukichi, Otsu-shi Shiga 520 (JP)
(74) Representative: Coleiro, Raymond
(86) International application number: PCT/JP89/00985
(87) International publication number: WO 90/03266

(56) References cited:
- EP-A- 41 850
- EP-A- 111 957
- DE-B- 1 092 269
- JP-A-54 139 978
- JP-B- 5 225 868
- JP-B- 5 751 725
- JP-B- 6 126 166
- THIN SOLID FILMS, vol. 149, no. 1, 11th May 1987, pages 105-111, Elsevier Sequoia, Lausanne , CH; D.J. BROWN: "Aluminized polyester films: influence of substrate on metal texture"
- SOLAR ENERGY MATERIALS, vol. 17, no. 3, April/May 1988, pages 207-215, Elsevier Science Publishers B.V., Amsterdam, NL; H.U. XINGFANG et al.: "Selectively absorbing black aluminium coating deposited by vacuum evaporation"

## Description

The present invention relates to a metallized film in which an aluminium layer is deposited on a plastic film which is wound or stacked into capacitors etc., and a process for producing it.

It is known that deposition of an aluminium layer on a substrate, in particular, a twisted flat cable, can be achieved by the respective steps of passing the substrate under vacuum between glow discharge plates and then moving the substrate under a reduced vacuum past a mask overlying a source of aluminium all under vacuum; see Bowles et al, IBM Technical Bulletin, (August 1966), 9(3), 245-246.

Where the substrate is a film, this can be metallized using a vacuum deposition apparatus in which winding and unwinding takes place in one (transit) chamber and vacuum deposition takes place in another (deposition) chamber (see US-A-3895129 and WO-A-88/00989). In US-A-3895129, an air leakage is provided in the transit chamber in order to prevent tapes, which have been metallized on both sides, from sticking together. In WO-A-88/00989, the transit chamber is at a pressure of about 10⁻²-10⁻³ torr, while the deposition chamber is at a pressure of about 10⁻⁴ torr.

In US 4,575,475 a substrate film is plasma treated on at least a surface of the film which is to bear a magnetic layer, to aid adhesion of the magnetic layer to the film. During the plasma treatment the reactor vessel is maintained at a vacuum of 0.01 to 10 Torr.

Metallized films in which an aluminium layer is deposited on a plastic film are broadly used as composites of electrodes and dielectrics for capacitors. However, aluminium does not have high chemical stability and, in particular, a layer of deposited aluminium generally lacks moisture resistance. In other words, because a deposited layer of aluminium has low durability with respect to corrosion in a high-temperature and high-humidity atmosphere, the layer is liable to lose its functional properties required for electrodes of a capacitor. Therefore, in a capacitor using such an aluminium deposited layer, generally its encapsulation is reinforced according to its environment in order to overcome the above defect. However, this reinforcement is often insufficient.

In a case where a deposited layer cannot be formed if the deposition material is directly deposited such as a case where zinc is deposited directly on a polypropylene film or a paper, or in a case where formation of a deposited layer is slow and therefore lacks industrial productivity, a process for assisting the formation of the deposited layer by predepositing a metal such as copper or silver which is to provide a nuclei for the formation of the zinc deposited layer (so-called, nucleation) is known, for example, as disclosed in JP-A-SHO-58-16415. However, the object, operation and advantage of such nucleation are quite different from those of the present invention. Actually, even if the nucleation is performed when zinc is deposited, increase of corrosion resistance of a deposited layer in a high-temperature and high-humidity atmosphere which the present invention seeks to provide cannot be achieved.

The present invention seeks to provide a solution to the above problem in the conventional metallized films having a deposited aluminium layer and to provide a metallized film which, when it is used for a capacitor, can have sufficiently high moisture resistance even if the encapsulation of the capacitor is simple, or can greatly increase the reliability of the moisture resistance when the encapsulation similar to that in a conventional capacitor is applied. The invention also seeks to provide a process for producing such a metallized film.

According to a first aspect, the present invention provides a metallized film in which a thin layer of aluminium is formed on at least one surface of a plastic film by vacuum deposition characterized in that a surface area coefficient C of the surface of the deposited layer is not greater than 1.00 x 10⁻⁴. The surface area coefficient C is determined by the equation$\text{C = (Lb - La) / La}$
wherein La and Lb are determined from a roughness curve obtained using a two beam type scanning electron microscope, La represents the projected length of the roughness curve on a base line and Lb represents the length of the roughness curve.

According to a second aspect, the present invention provides a metallized film in which a thin layer of aluminium is formed on at least one surface of a plastic film by vacuum deposition characterized in that the aluminium thin layer contains aluminium crystals [1,1,0] planes of which are oriented in parallel with the surface of the plastic film.

According to a third aspect, the present invention provides a process for producing a metallized film in which a layer of aluminium is formed on a plastic film by vacuum deposition characterized in that a layer of at least one metal selected from gold, silver, copper, nickel and tin is deposited on the plastic film in an amount not less than 0.1 mg/m² and not greater than 50 mg/m², and then aluminium is deposited on the said metal layer.

According to a fourth aspect, the present invention provides a process for producing a metallized film in which a layer of aluminium is formed on a plastic film by vacuum deposition characterized in that a surface of the plastic film on which the aluminium layer is to be deposited is plasma treated in an inert gas atmosphere with a degree of vacuum of 1.0 x 10⁻¹ to 1.0 x 10⁻³ torr at an intensity of not less than 5 W min/m² and not greater than 300 W min/m², and then aluminium is deposited on the treated surface in an atmosphere with a degree of vacuum of not greater than 1.0 x 10⁻³ torr, by an apparatus having a compartment for plasma treatment and a compartment for aluminium deposition in a single vacuum chamber, the degrees of vacuum of the compartments being controlled independently of each other.

When the metallized film according to the present invention is used for a capacitor, it can have a sufficiently high moisture resistance even if the encapsulation of the capacitor is simple. Moreover, if the encapsulation is similar to that in a conventional capacitor, a capacitor having an excellent reliability of moisture resistance can be obtained.

According to a fifth aspect, the present invention provides the use, for preparing a metallised film as defined above, of a metal selected from at least one of gold, silver, copper, nickel and tin for deposition on the plastic film in an amount not less than 0.1 mg/m² and not greater than 50 mg/m² to form a layer of the metal, and forming on the layer of the metal the layer of aluminium by vacuum deposition.

In a further aspect, the present invention provides the use, for preparing a metallised film as defined above, of an apparatus having a compartment for plasma treatment and a compartment for aluminium deposition in a single vacuum chamber, which plasma treatment compartment contains an inert gas atmosphere therein with a degree of vacuum of from 1.0 x 10⁻¹ to 1.0 x 10⁻³ torr and is charged to an intensity of not less than 5 W min/m² and not greater than 300 W min/m² and which aluminium deposition compartment contains a source of aluminium and has an atmosphere therein with a degree of vacuum not greater than 1.0 x 10⁻³ torr, the degree of vacuum in which plasma treatment and aluminium deposition compartments respectively being independently controlled, and in which apparatus the plastics film is passed through the plasma treatment compartment and thereafter through the aluminium deposition compartment.

Preferred embodiments of the invention will now be described.

In embodiments of the present invention, the plastic film, which may be regarded as a base film on which the aluminium layer is vacuum deposited, is a thin layer formed from a polymeric resin, i.e., a material generally called a film or a sheet. For example, it may be sheet-like material whose component is a polyethylene, polypropylene, polyethylene terephthalate, polyethylene naphthalate, polybutylene terephthalate, polycarbonate, polyallylate, polyphenylenesulphide, polyphenylenesulphideketone, polyetheretherketone, polyetherimide, polyimide, polyamide or fluorocarbon resin; or a resin of a mixture or copolymer of these resins. Among the films formed from the above resins, a film formed from a thermoplastic resin having an aromatic ring in its principal chain is effective for the present invention. Particularly, a film formed from at least one resin selected from polyethylene terephthalate, polyethylene naphthalate, polyphenylenesulphide, polyphenylenesulphideketone and polyetheretherketone is preferable from the viewpoint of film forming ability and the heat resistance of the film obtained. Furthermore, a biaxially stretched film formed from a resin of polyethylene terephthalate, polyethylene naphthalate or polyphenylenesulphide is more preferable.

In a metallized film embodying the present invention, an additional resin other than the above-described resins may be copolymerized or blended with the resin of the plastic film in an amount which does not impair the advantageous properties which the present invention seeks to provide. The copolymerized amount of such an additional resin is preferably not greater than 20 mol%, more preferably not greater than 10 mol%. The blended amount of such an additional resin is preferably not greater than 30 wt%, more preferably not greater than 20 wt%. Furthermore, inorganic or organic additives may be added in an amount which does not impair the advantageous properties which the present invention seeks to provide.

The metallized film according to the present invention is a film made by a process in accordance with the invention in which a thin layer of aluminium is formed on at least one surface of a plastic film by vacuum deposition. However, it is not necessary that the deposited layer be entirely of aluminium, and other metal or non-metallic substances may simultaneously or sequentially be deposited for the purpose of increasing the strength of the deposited layer, the moisture resistance of the deposited layer and the characteristics of a capacitor in which the film is utilized. Alternatively, other kinds of substance may be preformed on a plastic film for a similar purpose by, for example, coating, and thereafter, the thin layer of aluminium may be deposited so as to provide a metallised film according to the present invention. Furthermore, other films, resins or waxes may further be laminated or coated on the aluminium thin layer or the nonmetallic layer.

The thickness of the aluminium thin layer is not particularly restricted. When the thickness is in the range of 200 Å to 1000 Å, however, the advantages provided by the present invention become greater. This range of the thicknesses corresponds nearly to a range of 0.5 Ω to 5 Ω in the surface resistivity of a metallized film.

In the metallized film according to one aspect of the present invention, the surface area coefficient C of the surface of the deposited layer must be not greater than 1.00 x10⁻⁴, C being determined by equation (I):$\text{C = (Lb - La) / La}$
wherein La and Lb are determined from a roughness curve obtained using a two beam type scanning electron microscope. La represents the projected length of the roughness curve on a base line and Lb represents the length of the roughness curve.

Namely, La and Lb (the length of the roughness curve) are determined by equation (II):$\begin{matrix}\begin{matrix}\text{La = n·Δx} \\ \text{Lb =} \text{i=1} \text{n} {\text{[(Δx}}^{\text{2}} {\text{+ (y}}_{\text{i}} {\text{- y}}_{\text{i-1}} {\text{)}}^{\text{2}} {\text{]}}^{\text{1/2}}\end{matrix}\end{matrix}$
wherein "x" and "y" represent the coordinates on the axis in the direction of scanning for measuring the roughness and generating a roughness curve using the two beam type scanning electron microscope and on the axis in the height direction of the curve perpendicular to the scanning direction axis, respectively. When the x axis of the roughness curve is divided at intervals of "Δx" in the scanning direction and the coordinates of the roughness curve are x₀, x₂, x₂, x₃, ---, xₙ₋₁, xₙ in order, "yᵢ" represents corresponding coordinates of the roughness curve in its height direction which are y₀, y₁, y₂, y₃, ---, yₙ₋₁, yₙ. " x" and "n" are set to Δx = 0.05 µm and n≥10 in determining coefficient C in accordance with an aspect of the present invention. Details of the measuring conditions of the two beam type scanning electron microscope will be described later as an item in a series of explanations of methods for estimating various relevant characteristics.

In a metallized film according to another aspect of the present invention, the thin layer of aluminium must contain aluminium crystals [1, 1, 0] planes of which are oriented in parallel with the surface of a base film. The orientation of the aluminium crystals is determined by X-ray diffraction. Details of the method of determination will be described as an item in the abovementioned series of explanations. Only the diffraction peaks due to the aluminium crystals are extracted from the diffraction pattern determined by X-ray diffraction by subtracting the value of the diffraction due to the base film and additives from the diffraction pattern. In this determination, when the height of peak of diffraction by [2, 2, 0] plane (the distance between lattice planes: 1,431 Å) is not less than 3 % (preferably not less than 10 %) of the height of the peak of diffraction by the [1, 1, 1] plane (the distance between lattice planes: 2,338 Å), it is judged that the [1, 1, 0] planes of aluminium crystals are oriented in parallel with the surface of the base film.

In the present invention, if either the aforementioned surface area coefficient C or the above-described orientation of the aluminium crystals is satisfied, the advantages which the present invention seeks to provide can be realized. Of course, both of the characteristics may be satisfied at the same time. The value of the surface area coefficient C and the characteristic of the orientation of the aluminium crystals do not change even after producing a capacitor, and therefore, the value and the characteristic can be determined from a sample of the metallized film taken out from the capacitor.

Next, processes for producing metallized films according to the present invention will be explained.

In a first production process, at least one metal selected from gold, silver, copper, nickel and tin is deposited on a plastic film in an amount not less than 0.1 mg/m² and not greater than 50 mg/m², and then aluminium is deposited on the deposited metal layer. This process is effective when the surface of the plastic film which is to receive the aluminium layer is formed from a thermoplastic resin having an aromatic ring in its principal chain and, in particular, is very effective when the thermoplastic resin is one selected from polyethylene terephthalate, polyethylene naphthalate, polyphenylenesulphide and polyetheretherketone, and among these resins, extremely effective when the main component of the film is polyethylene terephthalate or polyphenylenesulphide.

In the process, at least one kind of metal (hereinafter, called primer) selected from gold, silver, copper, nickel and tin is deposited on a plastic film in a deposited amount of not less than 0.1 mg/m² and not greater than 50 mg/m² by vacuum deposition prior to vacuum deposition of aluminium on the plastic film. The amount deposited can be determined by secondary ion mass spectrum analysis (so-called SIMS), and the above range of amounts deposited corresponds to the range of peak intensities of the primer element of 10 to 10⁵ counts when the film is analyzed in the thickness direction from the surface of the deposited aluminium layer after the aluminium deposition is conducted (the conditions of analysis are described as an item in the abovementioned series of explanations of methods for estimating characteristics). As the primer, among the above metals copper is preferable from the viewpoint of easy deposition. The atmosphere for the deposition of the primer is preferably at a pressure not greater than 5.0 x 10⁻⁴ torr. The process for this deposition is not particularly restricted. Thus, although broadly used processes such as crucible and heater system or wire feeder and heater system can be applied when the production is industrially performed, the process for the deposition is not restricted to these systems.

When at least the surface of the plastic film on which the aluminium is to be deposited is formed from polyphenylenesulphide, it is desirable that a discharge treatment such as corona treatment or plasma treatment is previously performed on the surface to be subjected to deposition with the primer, from the viewpoint of increasing the adhesive ability between the plastic film and the deposited layer.

After the deposition of the primer, aluminium is deposited on the primer. When the thickness of the aluminium layer is in the range of 200 Å to 1000 Å, the effect due to the present invention is great. The atmosphere for the aluminium deposition is preferably at a pressure not greater than 5.0 x 10⁻⁴ torr. In addition, in the aluminium deposition, although broadly used processes such as crucible and heater system or wire feeder and heater system can be used when the production is industrially performed, the process for the deposition is not restricted to these systems.

The primer deposition and the aluminium deposition may be continuously conducted by, for example, use of a vacuum chamber having two evaporation sources therein. Alternatively, the depositions may be sequentially conducted by two steps of depositing a primer film and thereafter depositing aluminium on the primer film by a conventional process. The former continuous process is preferable from the point of view of productivity.

In another process aspect of the invention for producing a metallized film, a surface of a plastic film on which a layer of aluminium is to be deposited is plasma treated in an inert gas atmosphere with a degree of vacuum of 1.0 x 10⁻¹ to 1.0 x 10⁻³ torr at an intensity of not less than 5 W min/m² and not greater than 300 W min/m², and then aluminium is deposited on the treated surface in an atmosphere with a degree of vacuum of not greater than 1.0 x 10⁻³ torr, by an apparatus having a compartment capable of receiving the inert gas for plasma treatment and a compartment for aluminium deposition in a single vacuum chamber, the degrees of vacuum of the compartments being controlled independently from each other. This process is effective particularly when the surface of the plastic film on which the aluminium is to be deposited is formed from a polyester having an aromatic ring in its principal chain such as polyethylene terephthalate or polyethylene naphthalate.

In this process, the plasma treatment is conducted in an inert gas atmosphere having a degree of vacuum of 1.0 x 10⁻¹ to 1.0 x 10⁻³ torr. If the degree of vacuum is greater than 1.0 x 10⁻¹ torr, the effect due to the treatment is insufficient. If the degree of vacuum is smaller than 1.0 x 10⁻³ torr, discharge becomes nonuniform and the treatment is insufficient. In order to conduct the treatment uniformly in such an atmosphere, an apparatus wherein a substantial length of an electron beam from a discharge electrode is provided (a so-called magnetron) is preferably used. The inert gas is a gas containing an element selected from VIII group in the periodic table preferably at not less than 99 % in volume ratio. The content of gas containing oxygen such as oxygen gas, carbon monoxide gas or carbon dioxide gas is preferably suppressed to a volume ratio of not greater than 0.1 %. As the inert gas, argon is preferable from the viewpoint of handling ability etc.

The plasma treatment is conducted at an intensity of not less than 5 W min/m² and not greater than 300 W min/m². If the intensity is less than 5 W min/m², the effect due to the treatment is insufficient. If the intensity is greater than 300 W min/m², the damage to the film becomes great.

The aluminium deposition must be performed successively to the above plasma treatment under reduced pressure without returning the reduced pressure to atmospheric pressure, in order to achieve the object of the present invention. For this, an apparatus which has a compartment for plasma treatment and a compartment for aluminium deposition in a single vacuum chamber and allows control of the degrees of vacuum of the compartments independently from each other is required. Such an apparatus can be provided, for example, by reconstructing a conventional continuously winding type vacuum deposition apparatus having two separate compartments for winding and deposition such that the degree of vacuum of the compartment for winding can be independently controlled and the compartment for winding can be used as a compartment for plasma treatment by providing a plasma generator in the compartment, or by providing a third compartment between an unwinding portion and the compartment for deposition of the usual deposition apparatus and constituting this third compartment as a compartment for plasma treatment which allows control of its degree of vacuum independently. However, the required apparatus is not restricted to these apparatuses. In any case, since the plasma treatment must be performed in an inert gas atmosphere, a structure for charging the inert gas is required for a compartment functioning as a compartment for plasma treatment.

The aluminium deposition is conducted in an atmosphere having a degree of vacuum of not greater than 1.0 x 10⁻³ torr. If the degree of vacuum is greater than this value, the deposited layer obtained becomes very brittle and sufficient corrosion resistance cannot be obtained. More preferably, the degree of vacuum for the aluminium deposition is not greater than 2.0 x 10⁻⁴ torr. Furthermore, the effect due to the present invention is greater when the thickness of the aluminium deposited layer is in the range of 200 to 1000 Å.

Next, methods for determining and estimating characteristics relevant to the present invention will be explained.

### (1) Determination of roughness curve by a two beam type scanning electron microscope:

A cross-sectional chart is drawn by carrying out measurements on a deposited aluminium film at 200 points in the horizontal direction, using a two beam and two detector type scanning electron microscope and a cross section measuring apparatus for the microscope. The measuring conditions are as follows.

### Apparatus:

(a) two beam and two detector type scanning electron microscope: ESM-3200 produced by Elionics Corporation
(b) cross section measuring apparatus for the microscope: PSM-1 produced by Elionics Corporation

### Measuring conditions:

- magnification: : 150,000 times
- gain: : 15 kV
- bias: : 6.0
- spot size: : 5.50

### (2) Determination of orientation of aluminium crystal in thin aluminium layer by X-ray diffraction:

A sample is made by stacking three metallized films in a state such that the metallized surfaces thereof are arranged in the same direction. θ - 2θ scanning is repeated three times, and three measurements of wide angle X-ray diffraction are conducted. The measuring conditions are as follows.

### X-ray generator:

RU-200B (rotatory anode type) produced by Rigaku Denkisha (a Japanese company)
X-ray source: Cu-K_{α} radiation (X-ray generator with graphite-monochromated Cu-K_{α} radiation is used.)
output: 40 kV, 100 mA

### Goniometer:

2155-D type produced by Rigaku Denkisha slit system: 1°-0.15mm-1°
detector: scintillation counter

### Recorder for counting:

RAD-B type produced by Rigaku Denkisha

### (3) Determination of deposited amount of primer by secondary ion mass spectrum analysis (SIMS):

When a deposited aluminium film is assessed from the surface of the aluminium layer in the thickness direction by secondary ion mass spectrum analysis according to the following measuring conditions, the peak intensity (counted number of secondary ion) of the primer element coming out at the boundary between the aluminium layer and the film is determined. Here, the boundary between the aluminium layer and the film is defined as an area from a first transition point of the intensity of an element peculiar to the film (for example, carbon) to a stationary point thereof.

### Measuring conditions:

Apparatus: A-DIDA 3000 produced by ATOMIKA (West Germany)
Primary ion: O₂⁺
Acceleration voltage for primary ion: 12 kV
Current of primary ion: 80 nA
Raster area: 400 µm□
Analysis area: gate 20 %
Degree of vacuum for determination: 1 x 10⁻⁸ torr
   - E-GUN:: 0.5 kV, 3.0 A (Focus; 6.5)
   - H-Q-H:: #13

### (4) Corrosion resistance:

A sample is made by cutting a metallized film to a size of 5 cm x 5 cm, and the sample is soaked in a thermostatic water bath containing therein distilled water controlled at 65°C. The surface resistivity of the sample is traced, the time required for increasing the surface resistivity to a value ten times the initial value is determined, and the resulting data is ranked in accordance with the following criteria A to E. The longer is this time, the better is corrosion resistance.
A --- not less than 60 minutes
B --- not less than 40 minutes and less than 60 minutes
C --- not less than 20 minutes and less than 40 minutes
D --- not less than 10 minutes and less than 20 minutes
E --- less than 10 minutes

### (5) Moisture resistance of a capacitor:

A capacitor is aged for 1000 hours under conditions of 60°C and 95 %RH, and thereafter, the proportional change in the capacitance is determined. The proportion is indicated by ΔC/C, and this provides the resulting data for moisture resistance. Here, "C" is the capacitance before aging, and "ΔC" is the change in capacitance before and after aging. The larger is the absolute value of this proportion, the worse is moisture resistance. In the determination, the capacitance of a capacitor is measured using an automatic capacitance bridge.

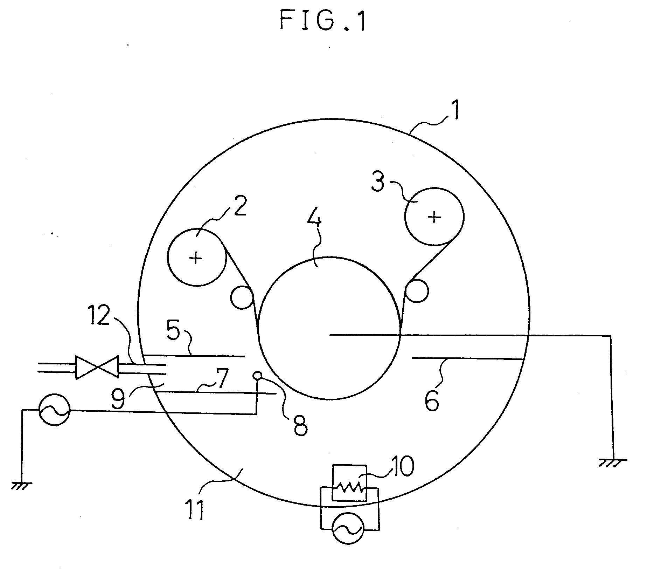

Next, embodiments of the present invention will be explained in more detail with reference to the following Examples, which refer also to the accompanying Fig. 1, which is a diagram showing an apparatus for carrying out one of the process aspects of the invention for producing a metallized film in which aluminium is deposited on a plastic film, and in which a compartment for plasma treatment and a compartment for aluminium deposition are both provided in a single vacuum chamber.

### Example 1

The compartment for deposition of a continuous winding type metallizer (produced by Nihon Shinku Gijutsu Corporation) was divided into two compartments, and the metallizer was reconstructed so that copper could be deposited in the divided front compartment (unwinding side) and aluminium could be deposited in the rear compartment (winding side). Using this apparatus, copper was deposited on a polyethylene terephthalate film ("Lumirror" produced by Toray Industries, Inc., the thickness of the film : 4µm) in an amount of 0.5 mg/m² in the front compartment. Then, aluminium was deposited in the successive rear compartment such that the surface resistivity was 2 Ω, and thus a metallized film was obtained. The film obtained is referred to as MF-Al. The resulting data for the surface area coefficient C of MF-A1 and the determination of orientation of aluminium crystals in the thin aluminium layer of MF-Al are shown in Table 1. Margins (non-conducting portions) having a width of 1.0 mm and extending in the form of a strip in the longitudinal direction of MF-A1 were formed at a pitch of 9 mm by reevaporation of the metal using a YAG laser. Cutters were inserted into the centre of each of the deposited portions (width: 8.0 mm) and the centre of each of the margins (width: 1.0 mm), and slitting was conducted. Tapes each having a width of 4.5 mm and having a margin with a width of 0.5 mm on its left or right side were made and wound.

One such tape with a left-side margin and another such tape with a right-side margin were wound together around a core, and thus, a wound body having a capacitance of about 0.1 µF was obtained. The core was then drawn out from the wound body and the wound body was then heat pressed (120°C, 30 kg/cm², 5 minutes). An aluminium alloy was sprayed onto both end faces of the wound body to make external electrodes, and a capacitor was made by welding lead wires to the metal alloy portions. The capacitor obtained is referred to as C-A1. The result of estimation of moisture resistance of C-A1 is shown in Table 1.

### Example A2

As shown in FIG. 1, in a continuous winding type metallizer (produced by Nihon Shinku Gijutsu Corporation) having a partition 5 between an unwinding portion including a unwinding roll 2 and a deposition compartment 11 and a partition 6 between the deposition compartment and a winding portion including a winding roll 3, another partition 7 having the same structure as that of the partition 5 was provided between the unwinding portion and the deposition compartment. A conduit pipe 12 was provided between partitions 5 and 7 such that a gas could be introduced between the partitions from outside. A high-voltage application electrode (magnetron) 8 was provided in parallel relation to the axis of a cooling can 4 earthed so as to constitute a counter electrode and spaced from the surface of the can at a distance of 10 mm. Thus, a compartment 9 for plasma treatment was newly provided. In FIG. 1, an induction heater is indicated by reference numeral 10.

Using this apparatus, plasma treatment was conducted on the surface of a polyethylene terephthalate film ("Lumirror" produced by Toray Industries, Inc., the thickness of the film : 4 µm) in an argon atmosphere having a degree of vacuum of 2.0 x 10⁻³ torr at a treatment intensity of 60 W min/m². Successively, aluminium was deposited on the film in an atmosphere having a degree of vacuum of 8.0 x 10⁻⁵ torr such that the surface resistivity of the film became 2 Ω. Thus, a metallized film was obtained. The thickness of the aluminium layer was about 350 Å. This film is referred to as MF-A2. The resulting data for the surface area coefficient C of MF-A2 and the determination of orientation of aluminium crystals in the thin aluminium layer are shown in Table 1.

A capacitor was made using MF-A2 in the same manner as that of Example A1. The capacitor obtained is referred, to as C-A2. The result of estimation of moisture resistance of C-A2 is shown in Table 1.

### Example A3

A metallized film was made in the same manner as that of Example A1 except that the film was a biaxially stretched polyphenylenesulphide film ("Torelina" produced by Toray Industries, Inc., the thickness of the film : 4 µm). This metallized film is is referred to as MF-A3. The resulting data for the surface area coefficient C of MF-A3 and the determination of orientation of aluminium crystals in the thin aluminium layer are shown in Table 1.

A capacitor was made using MF-A3 in the same manner as that of Example A1. The conditions of heat pressing were 180°C, 15 kg/cm² and 5 minutes. The capacitor obtained is referred to as C-A3. The result of estimation of moisture resistance of C-A3 is shown in Table 1.

### Example A4

A metallized film was made in the same manner as that of Example A2 except that the film was a biaxially stretched polyphenylenesulphide film ("Torelina" produced by Toray Industries, Inc., thickness of the film : 4 µm). The metallized film is referred to as MF-A4. The resulting data for the surface area coefficient C of MF-A4 and the determination of orientation of aluminium crystals in the thin aluminium layer are shown in Table 1.

A capacitor was made using MF-A4 in the same manner as that of Example A2. The conditions of heat pressing were 180°C, 15 kg/cm² and 5 minutes. The capacitor obtained is referred to as C-A4. The result of estimation of moisture resistance of C-A4 is shown in Table 1.

### Comparative Example A1

A metallized film was made by a conventional process, i.e., in the same manner as that of Example A1 except that there was no deposition of copper. Moreover, no plasma treatment was employed. This film is referred to as MF-A5. The resulting data for the surface area coefficient C of MF-A5 and the determination of orientation of aluminium crystals in the thin aluminium layer are shown in Table 1.

A capacitor was made using MF-A5 in the same manner as that of Example A1. The capacitor obtained is referred to as C-A5. The result of estimation of moisture resistance of C-A5 is shown in Table 1.

### Comparative Example A2

A metallized film was made by conventional process, i.e., in the same manner as that of Example A3 except that there was no deposition of copper. Moreover, no plasma treatment was employed. This film is referred to as MF-A6. The resulting data for the surface area coefficient C of MF-A6 and the determination of orientation of aluminium crystals in the thin aluminium layer are shown in Table 1.

A capacitor was made using MF-A6 in the same manner as that of Example A3. The capacitor obtained is referred to as C-A6. The result of estimation of moisture resistance of C-A6 is shown in Table 1.

### Examples B1-B11 and Comparative Examples B1-B7

Various metallized films were made in the same manner as that of Example A1 by changing base films, primers and the deposited amounts of the primers. These films are referred to as MF-B1 and MF-B18. The manufacturing conditions and the results of corrosion resistance thereof are shown in Table 2.

The polyethylene naphthalate film used as a base film for each of MF-B5 and MF-B12 was obtained by the following process.

Polyethylene-2,6-naphthalate having an ultimate (i.e. intrinsic)viscosity of 0.60 was polymerized from ethylene glycol and naphthalene-2,6-dicarboxylic acid by a conventional process. Then, 0.2 wt% calcium carbonate having a mean particle size of 1.2 µm was added to the polymer to obtain a polyethylene naphthalate resin. This resin was delivered out from an extruder equipped with a T-die in a form of a sheet. The sheet was rapidly cooled on a casting drum to obtain a substantially amorphous sheet. The sheet was sequentially stretched biaxially at draw ratios of 3.5 times and 3.5 times, and heat treated. Thus, a biaxially stretched polyethylene-2,6-naphthalate film having a thickness of 4 µm was obtained.

A polyetheretherketone film used as a base film for each of MF-B6 and MF-B13 was obtained by the following process.

A polyetheretherketone (PEEK 380G produced by I.C.I.) was delivered out from an extruder equipped with a T-die in a form of a sheet. The sheet was rapidly cooled on a casting drum to obtain a substantially amorphous sheet. The sheet was sequentially stretched biaxially at draw ratios of 2.5 times and 2.5 times, and heat treated. Thus, a biaxially stretched polyetheretherketone film having a thickness of 4 µm was obtained.

A polypropylene film "Torayfan" produced by Toray Industries, Inc. (thickness of the film: 4 µm) was used as a base film for each of MF-B7 and MF-B14.

### Examples C1-C10 and Comparative Examples C1-C10

Various metallized films were obtained using the apparatus used in Example A2 and using a biaxially stretched polyethylene terephthalate film ("Lumirror" produced by Toray Industries, Inc., thickness of the film: 2 µm) and a biaxially stretched polyphenylenesulphide film ("Torelina" produced by Toray Industries, Inc., thickness of the film : 2 µm) as base films, by changing the atmosphere for plasma treatment, the intensity of plasma treatment and the atmosphere for aluminium deposition. The films obtained are referred to as MF-C1 to MF-C20. The manufacturing conditions and the results of corrosion resistance thereof are shown in Table 3.

**Table 1**

| | Film No. | Surface area coefficient C | [1, 1, 0] Orientation of aluminium crystal | Moisture resistance of capacitor | |
|---|---|---|---|---|---|
| | | | | Capacitor No. | ΔC/C (%) |
| Example A1 | MF-A1 | 0.50x10⁻⁴ | present | C-A1 | +0.5 |
| Example A2 | MF-A2 | 0.81x10⁻⁴ | present | C-A2 | +0.0 |
| Example A3 | MF-A3 | 0.42x10⁻⁴ | present | C-A3 | +2.5 |
| Example A4 | MF-A4 | 0.73x10⁻⁴ | present | C-A4 | +0.0 |
| Comp.Ex. A1 | MF-A5 | 2.53x10⁻⁴ | none | C-A5 | -96.8 |
| Comp.Ex. A2 | MF-A6 | 1.85x10⁻⁴ | none | C-A6 | -63.4 |

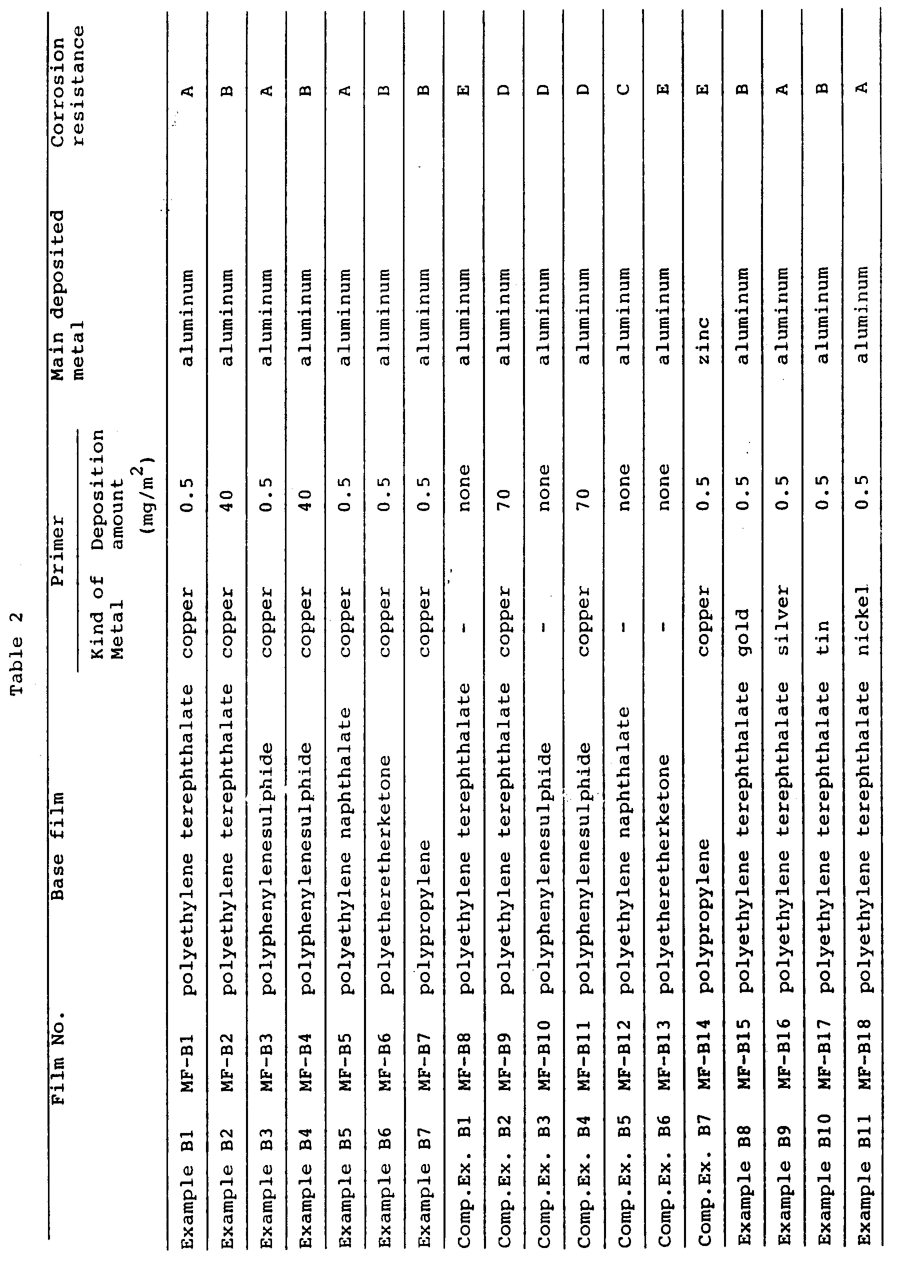

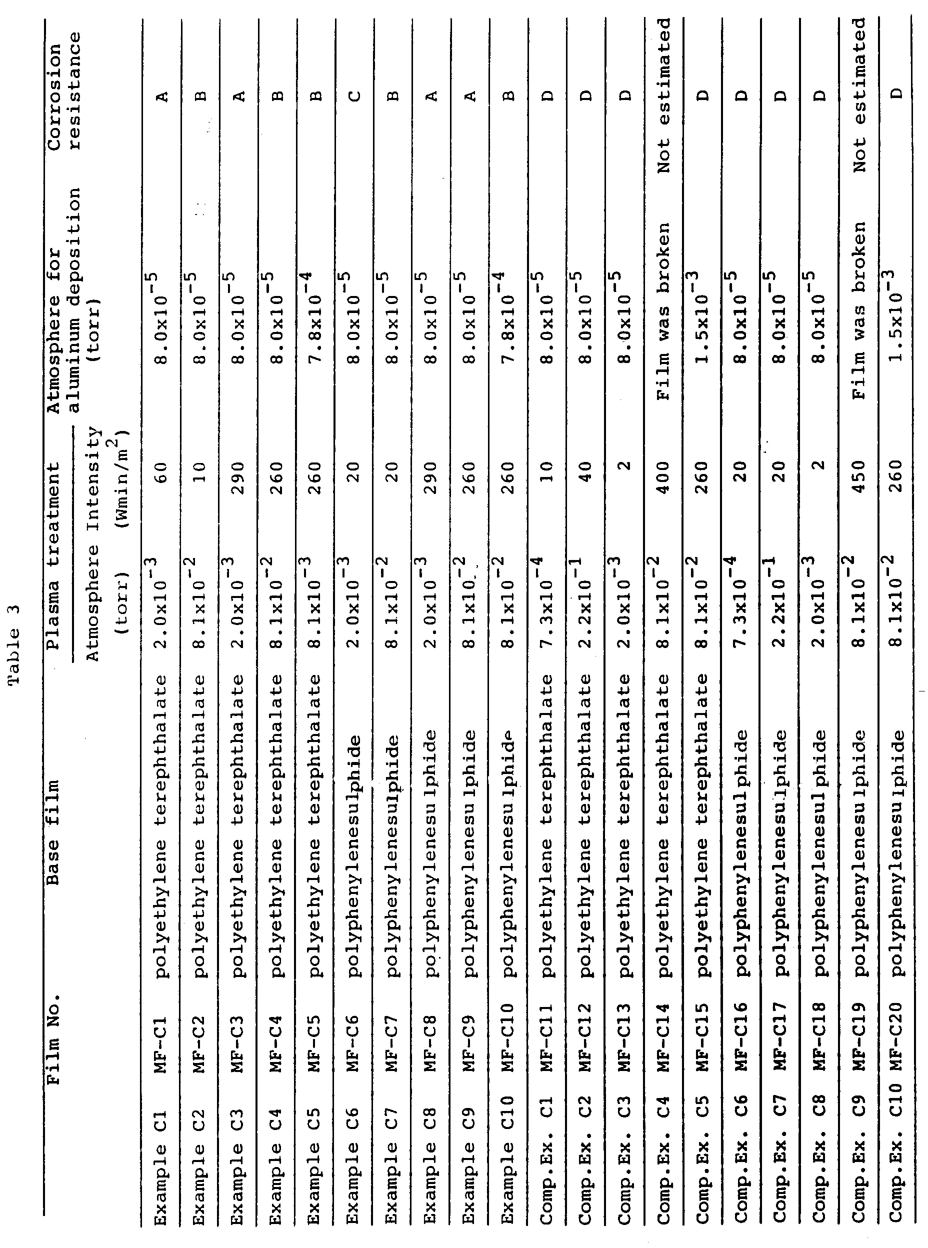

A metallized film having the above-described constitution according to the present invention can greatly improve the corrosion resistance of the aluminium layer in a high-temperature and high-humidity atmosphere which is a problem in a conventional metallized film having a deposited aluminium layer. As a result, a capacitor using this metallized film can have an excellent moisture resistance even if its encapsulation is simple, or can increase its moisture resistance to a great extent when its encapsulation is constructed in a manner similar to that of a conventional capacitor. Therefore, the industrial application of the present invention is very effective.

## Claims

1. A metallized film in which a thin layer of aluminium is formed on at least one surface of a plastic film by vacuum deposition characterized in that a surface area coefficient C of the surface of the aluminium layer is not greater than 1.00 x 10⁻⁴, which surface area coefficient C is determined by the equation (I)$\text{C = (Lb - La) / La}$
wherein La and Lb are determined from a roughness curve obtained using a two beam type scanning electron microscope, La represents the projected length of the roughness curve on a base line and Lb represents the length of the roughness curve.

2. A metallized film in which a thin layer of aluminium is formed on at least one surface of a plastic film by vacuum deposition characterized in that the aluminium layer contains aluminium crystals [1, 1, 0] planes of which are oriented in parallel with the surface of the plastic film.

3. A metallized film according to claim 1, wherein the aluminium layer contains aluminium crystals [1, 1, 0] planes of which are oriented in parallel with the surface of the plastic film.

4. A metallized film according to any preceding claim, wherein the plastic film is formed from a thermoplastic resin having an aromatic ring in its principal chain.

5. A metallized film according to claim 4, wherein the plastic film is formed from at least one resin selected from polyethylene terephthalate, polyethylene naphthalate, polyphenylenesulphide, polyphenylenesulphideketone and polyetheretherketone.

6. A metallized film according to any preceding claim, wherein the plastic film is a biaxially stretched film.

7. A process for producing a metallized film in which a layer of aluminium is formed on a plastic film by vacuum deposition characterized in that a layer of at least one metal selected from gold, silver, copper, nickel and tin is deposited on the plastic film in an amount not less than 0.1 mg/m² and not greater than 50 mg/m², and then aluminium is deposited on the said metal layer.

8. A process for producing a metallized film in which a layer of aluminium is formed on a plastic film by vacuum deposition characterized in that a surface of the plastic film on which the aluminium layer to be deposited is plasma treated in an inert gas atmosphere with a degree of vacuum of 1.0 x 10⁻¹ to 1.0 x 10⁻³ torr at an intensity of not less than 5 W min/m² and not greater than 300 W min/m², and then aluminium is deposited on the treated surface in an atmosphere with a degree of vacuum of not greater than 1.0 x 10⁻³ torr, by an apparatus having a compartment containing the inert gas for the plasma treatment and a compartment in which the aluminium is deposited in a single vacuum chamber, the degrees of vacuum of one said compartments being controlled independently of the degree of vacuum in the other.

9. A process according to claim 7 or 8, wherein the plastic film is formed from a thermoplastic resin having an aromatic ring in its principal chain.

10. A process according to claim 9, wherein the plastic film is formed from at least one resin selected from polyethylene terephthalate, polyethylene naphthalate, polyphenylenesulphide, polyphenylenesulphideketone and polyetheretherketone.

11. A process according to any of claims 7 to 10, wherein the plastic film is a biaxially stretched film.

12. Use for preparing a metallised film as claimed in any one of claims 1 to 6, of a metal selected from at least one of gold, silver, copper, nickel and tin for deposition on the plastic film in an amount not less than 0.1 mg/m² and not greater than 50 mg/m² to form a layer of the metal, and forming on the layer of the metal the layer of aluminium by vacuum deposition.

13. Use, for preparing a metallised film as claimed in any one of claims 1 to 6, of an apparatus having a compartment for plasma treatment and a compartment for aluminium deposition in a single vacuum chamber, which plasma treatment compartment contains an inert gas atmosphere therein with a degree of vacuum of from 1.0 x 10⁻¹ to 1.0 x 10⁻³ torr and is charged to an intensity of not less than 5 W min/m² and not greater than 300 W min/m² and which aluminium deposition compartment contains a source of aluminium and has an atmosphere therein with a degree of vacuum not greater than 1.0 x 10⁻³ torr, the degree of vacuum in which plasma treatment and aluminium deposition compartments respectively being independently controlled, and in which apparatus the plastics film is passed through the plasma treatment compartment and thereafter through the aluminium deposition compartment.

## Patentansprüche

1. Metallisierter Film, bei dem eine dünne Aluminiumschicht durch Vakuumabscheidung auf zumindest einer Oberfläche eines Kunststoff-Films ausgebildet ist, dadurch gekennzeichnet, daß ein Oberflächenkoeffizient C der Oberfläche der Aluminiumschicht nicht größer als 1,00 x 10⁻⁴ ist, wobei der Oberflächenkoeffizient C durch die Gleichung (I) gegeben ist:$\text{C = (Lb - La) / La}$ worin La und Lb aus einer Rauhigkeitskurve bestimmt sind, die unter Verwendung eines Doppelstrahl-Rasterelektronenmikroskops erhalten wird, La die Länge der auf die Grundlinie projizierten Rauhigkeitskurve darstellt und Lb die Länge der Rauhigkeitskurve darstellt.

2. Metallisierter Film, bei dem eine dünne Aluminiumschicht durch Vakuumabscheidung auf zumindest einer Oberfläche eines Kunststoff-Films ausgebildet ist, dadurch gekennzeichnet, daß die Aluminiumschicht Aluminiumkristalle enthält, wovon [1, 1, 0]-Ebenen mit der Oberfläche des Kunststoff-Films parallel ausgerichtet sind.

3. Metallisierter Film nach Anspruch 1, worin die Aluminiumschicht Aluminiumkristalle enthält, wovon [1, 1, 0]-Ebenen mit der Oberfläche des Kunststoff-Films parallel ausgerichtet sind.

4. Metallisierter Film nach einem der vorangegangenen Ansprüche, worin der Kunststoff-Film aus einem thermoplastischen Harz gebildet ist, das einen aromatischen Ring in seiner Hauptkette aufweist.

5. Metallisierter Film nach Anspruch 4, worin der Kunststoff-Film aus zumindest einem Harz gebildet ist, das aus Polyethylenterephthalat, Polyethylennaphthalat, Polyphenylensulfid, Polyphenylensulfidketon und Polyetheretherketon ausgewählt ist.

6. Metallisierter Film nach einem der vorangegangenen Ansprüche, worin der Kunststoff-Film ein biaxial gereckter Film ist.

7. Verfahren zur Herstellung eines metallisierten Films, worin eine Aluminiumschicht durch Vakuumabscheidung auf einem Kunststoff-Film ausgebildet wird, dadurch gekennzeichnet, daß die Schicht aus zumindest einem Metall, ausgewählt aus Gold, Silber, Kupfer, Nickel und Zinn, in einer Menge von nicht unter 0,1 mg/m² und nicht über 50 mg/m² auf dem Kunststoff-Film abgelagert wird und dann auf der Metallschicht Aluminium abgelagert wird.

8. Verfahren zur Herstellung eines metallisierten Films, bei dem eine Aluminiumschicht durch Vakuumabscheidung auf einem Kunststoff-Film ausgebildet wird, dadurch gekennzeichnet, daß eine Oberfläche des Kunststoff-Films, auf der die Aluminiumschicht abzulagern ist, in einer Inertgas-Atmosphäre mit einer Vakuumgüte von 1,0 x 10⁻¹ bis 1,0 x 10⁻³ Torr mit einer Intensität von nicht weniger als 5 W.min/m² und nicht mehr als 300 W.min/m² plasmabehandelt wird und das Aluminium dann mittels einer Vorrichtung, die ein Abteil, welches das Inertgas für die Plasmabehandlung enthält, sowie ein Abtei aufweist, in dem das Aluminium in einer einzelnen Vakuumkammer abgelagert wird, auf der behandelten Oberfläche in einer Atmosphäre mit einer Vakuumgüte von nicht über 1,0 x 10⁻³ Torr abgelagert wird, wobei die Vakuumgüten in einem Abteil unabhängig von der Vakuumgüte im anderen reguliert werden.

9. Verfahren nach Anspruch 7 oder 8, worin der Kunststoff-Film aus einem thermoplastischen Harz mit einem aromatischen Ring in seiner Hauptkette gebildet ist.

10. Verfahren nach Anspruch 9, worin der Kunststoff-Film aus zumindest einem Harz gebildet ist, das aus Polyethylenterephthalat, Polyethylennaphthalat, Polyphenylensulfid, Polyphenylensulfidketon und Polyetheretherketon ausgewählt ist.

11. Verfahren nach einem der Ansprüche 7 bis 10, worin der Kunststoff-Film ein biaxial gereckter Film ist.

12. Verwendung eines Metalls, das aus zumindest einem von Gold, Silber, Kupfer, Nickel und Zinn ausgewählt ist, zur Ablagerung auf dem Kunststoff-Film in einer Menge von nicht unter 0,1 mg/m² und nicht über 50 mg/m², um eine Schicht aus dem Metall zu bilden, und Ausbilden der Aluminiumschicht durch Vakuumabscheidung auf der Schicht aus dem Metall, um einen metallisierten Film nach einem der Ansprüche 1 bis 6 herzustellen.

13. Verwendung einer Vorrichtung, die ein Abteil zur Plasmabehandlung und ein Abteil zur Aluminiumablagerung in einer einzigen Vakuumkammer aufweist, wobei das Plasmabehandlungsabteil eine Inertgas-Atmosphäre mit einer Vakuumgüte von 1,0 x 10⁻¹ bis 1,0 x 10⁻³ Torr enthält und bis zu einer Intensität von nicht weniger als 5 W.min/m² und nicht mehr als 300 W min/m² geladen ist, und wobei das Aluminiumablagerungsabteil eine Aluminiumquelle enthält und eine Atmosphäre darin mit einer Vakuumgüte von nicht über 1,0 x 10⁻³ Torr aufweist, wobei die Vakuumgüte im Plasmabehandlungs- bzw. im Aluminiumablagerungsabteil unabhängig vom jeweils anderen reguliert wird, und in welcher Vorrichtung der Kunststoff-Film durch das Plasmabehandlungsabteil und daraufhin durch das Aluminiumablagerungsabteil geführt wird, um einen metallisierten Film nach einem der Ansprüche 1 bis 6 herzustellen.

## Revendications

1. Film métallisé dans lequel une couche mince d'aluminium est formée sur au moins une surface d'un film plastique par dépôt sous vide, caractérisé en ce qu'un coefficient C d'aire superficielle de la surface de la couche d'aluminium n'est pas plus grand que 1,00 x 10⁻⁴, lequel coefficient d'aire superficielle C est déterminé par l'équation (I)$\text{C = (Lb - La) / La}$
où La et Lb sont déterminées à partir d'une courbe de rugosité obtenue en utilisant un microscope électronique à balayage du type à deux faisceaux, La représente la longueur projetée de la courbe de rugosité sur une ligne de base et Lb représente la longueur de la courbe de rugosité.

2. Film métallisé dans lequel une couche mince d'aluminium est formée sur au moins une surface d'un film plastique par dépôt sous vide, caractérisé en ce que la couche d'aluminium contient des cristaux d'aluminium [1, 1, 0] dont des plans sont orientés parallélement à la surface du film plastique.

3. Film métallisé selon la revendication 1, où la couche d'aluminium contient des cristaux d'aluminium [1, 1, 0] dont des plans sont orientés parallèlement à la surface du film plastique.

4. Film métallisé selon l'une des revendications précédentes, où le film plastique est formé d'une résine thermoplastique ayant un cycle aromatique dans sa chaîne principale.

5. Film métallisé selon la revendication 4, où le film plastique est formé d'au moins une résine sélectionnée parmi le téréphtalate de polyéthylène, le naphtalate de polyéthylène, le sulfure de polyphénylène, la polyphénylènesulfuredicétone et la polyétheréthercétone.

6. Film métallisé selon toute revendication précédente, où le film plastique est un film biaxialement étiré.

7. Procédé de production d'un film métallisé dans lequel une couche d'aluminium est formée sur un film plastique par dépôt sous vide, caractérisé en ce qu'une couche d'au moins un métal sélectionné parmi l'or, l'argent, le cuivre, le nickel et l'étain est déposée sur le film plastique en une quantité qui n'est pas inférieure à 0,1 mg/m² et pas supérieure à 50 mg/m², puis l'aluminium est déposé sur ladite couche de métal.

8. Procédé de production d'un film métallisé dans lequel une couche d'aluminium est formée sur un film plastique par dépôt sous vide, caractérisé en ce qu'une surface du film plastique sur laquelle la couche d'aluminium doit être déposée est traitée au plasma dans une atmosphère d'un gaz inerte avec un degré de vide de 1,0 x 10⁻¹ à 1,0 x 10⁻³ torr à une intensité qui n'est pas inférieure à 5 W min/m² et pas supérieure à 300 W min/m², puis de l'aluminium est déposé sur la surface traitée dans une atmosphère avec un degré de vide qui ne dépasse pas 1,0 x 10⁻³ torr, par un appareil ayant un compartiment contenant le gaz inerte pour le traitement au plasma et un compartiment dans lequel l'aluminium est déposé dans une seule chambre à vide, les degrés de vide de l'un desdits compartiments étant contrôlés indépendamment du degré de vide de l'autre.

9. Procédé selon la revendication 7 ou 8, où le film plastique est formé d'une résine thermoplastique ayant un cycle aromatique dans sa chaîne principale.

10. Procédé selon la revendication 9, où le film plastique est formé d'au moins une résine sélectionnée parmi le téréphtalate de polyéthylène, le naphtalate de polyéthyléne, le sulfure de polyphénylène, la polyphénylènesulfuredicétone et la polyétheréthercétone.

11. Procédé selon l'une quelconque des revendications 7 à 10, où le film plastique est un film biaxialement étiré.

12. Utilisation, pour la préparation d'un film métallisé selon l'une des revendications 1 à 6, d'un métal sélectionné parmi au moins l'un de l'or, de l'argent, du cuivre, du nickel et de l'étain pour un dépôt sur le film plastique en une quantité qui n'est pas inférieure à 0,1 mg/m² et pas supérieure à 50 mg/m² pour former une couche du métal, et formation sur la couche de métal de la couche d'aluminium par dépôt sous vide.

13. Utilisation, pour la préparation d'un film métallisé selon l'une quelconque des revendications 1 à 6, d'un appareil ayant un compartiment pour le traitement au plasma et un compartiment pour le dépôt d'aluminium dans une seule chambre à vide, lequel compartiment pour le traitement au plasma contient une atmosphère d'un gaz inerte avec un degré de vide de 1,0 x 10⁻¹ à 1,0 x 10⁻³ torr et est chargé à une intensité de pas moins de 5 W min/m² et pas plus de 300 W min/m² et lequel compartiment de dépôt de l'aluminium contient une source d'aluminium et contient une atmosphère avec un degré de vide qui ne dépasse pas 1,0 x 10⁻³ torr, le degré de vide dans ces compartiments de traitement au plasma et de dépôt d'aluminium étant respectivement indépendamment contrôlé et appareil dans lequel le film plastique passe à travers le compartiment de traitement au plasma et ensuite à travers le compartiment de dépôt d'aluminium.
